# EUROPEAN PATENT APPLICATION

(11) **EP 4 647 530 A1**
(43) Date of publication of application: **12.11.2025**
(21) Application number: 23935020.0
(22) Date of filing: 15.11.2023
(51) Int. Cl.: C23F 15/00, G09F 9/30, H04M 1/02, C23C 22/00

(54) **ANTI-CORROSION METHOD, MAGNESIUM-CONTAINING ASSEMBLY AND ELECTRONIC DEVICE**

(30) Priority: 28.04.2023 CN 202310485419
(71) Applicant: Honor Device Co., Ltd., Shenzhen, Guangdong 518040 (CN)
(72) Inventor: MIAO, Yuan, Shenzhen, Guangdong 518040 (CN); YANG, Tao, Shenzhen, Guangdong 518040 (CN); DONG, Changfu, Shenzhen, Guangdong 518040 (CN)
(74) Representative: Isarpatent
(86) International application number: PCT/CN2023/131860
(87) International publication number: WO 2024/221852

(57) **Abstract**

This application provides an anti-corrosion method, a magnesium-containing assembly, and an electronic device. The anti-corrosion method is applied to a contact surface between a first structural member and a second structural member. The anti-corrosion method includes: attaching a composite film to the contact surface between the first structural member and the second structural member, where the composite film includes an adhesive film and Mylar. Based on the anti-corrosion method, an efficient galvanic corrosion inhibition effect can be achieved. The magnesium-containing assembly and the electronic device obtained based on the anti-corrosion method have good anti-corrosion effects.

## Description

This application claims priority to Chinese Patent Application No. 202310485419.X, filed with the China National Intellectual Property Administration on April 28, 2023 and entitled "ANTI-CORROSION METHOD, MAGNESIUM-CONTAINING ASSEMBLY, AND ELECTRONIC DEVICE", which is incorporated herein by reference in its entirety.

### TECHNICAL FIELD

This application relates to the field of metal anti-corrosion technologies, and in particular, to an anti-corrosion method, a magnesium-containing assembly, and an electronic device.

### BACKGROUND

As flexible foldable screen technologies are increasingly mature, flexible foldable terminal products have become a major trend. The foldable terminal products (such as foldable mobile phones, foldable tablets, foldable computers, and other electronic devices) need to meet high reliability, good operating experience, and good appearance, to be accepted by consumers. However, foldable terminals currently have a problem of large weight, which affects user experience. To provide foldable devices with better experience, weight reduction has become an important issue.

At present, to implement weight reduction of electronic devices, a magnesium alloy is selected as a raw material for manufacturing more and more structural members. This also makes it inevitable for the magnesium alloy to be in contact with, or even be electrically connected to, dissimilar metals (for example, a stainless steel fastener and plate). However, due to a large potential difference between the magnesium alloy (about -2.363 V) and the steel (about -0.441 V), the magnesium alloy is usually prone to severe galvanic corrosion. This not only affects connection strength, but also causes risks of jamming and foreign matter in a rotating shaft, and electrical connection failure. This problem also exists in foldable devices. Therefore, based on weight reduction of the foldable devices by using a magnesium alloy material, how to prevent corrosion of the magnesium alloy has become an important issue.

### SUMMARY

To resolve the foregoing technical problem, this application provides an anti-corrosion method, a magnesium-containing assembly, and an electronic device. Based on the anti-corrosion method of a magnesium-containing structure, efficient anti-corrosion can be implemented while a high heat dissipation capability of a structural member is maintained.

According to a first aspect, this application provides an anti-corrosion method, applied to a contact surface between a first structural member and a second structural member, where the anti-corrosion method includes: attaching a composite film to the contact surface between the first structural member and the second structural member, where the composite film includes an adhesive film and Mylar.

According to the first aspect, based on the anti-corrosion method of this application, for the contact surface with severe galvanic corrosion, directionally reinforced anti-corrosion is performed by attaching the adhesive film/Mylar composite film to the contact surface, thereby achieving a high anti-corrosion effect.

According to the first aspect or any implementation of the first aspect, a thickness of the composite film is 0.01 mm to 0.1 mm. Such moderate thickness of the composite film can ensure an anti-corrosion effect without taking up excessive space of the structural member.

According to the first aspect or any implementation of the first aspect, a length of the composite film is at least 0.02 mm greater than a length of the contact surface, and a width of the composite film is at least 0.02 mm greater than a width of the contact surface. In this way, the composite film can cover the contact surface, thereby ensuring an anti-corrosion effect, and preventing corrosion in an edge region of the contact surface.

According to the first aspect or any implementation of the first aspect, the first structural member is a magnesium-containing structural member, the second structural member is a steel structural member, the adhesive film in the composite film is attached to the first structural member, and the Mylar in the composite film faces the second structural member. In this way, the magnesium alloy body can be sealed, thereby effectively preventing entry of salt spray and other corrosive media, and an ion channel between the structural member made of the magnesium alloy and the structural member made of the steel can be blocked, thereby preventing galvanic corrosion between the structural member made of the magnesium alloy and the structural member made of the steel.

According to the first aspect or any implementation of the first aspect, a chemical conversion film is formed on a surface of the first structural member. In this way, overall anti-corrosion is performed in a non-contact weak corrosion region between the first structural member and the second structural member by using a salt chemical conversion film with a small thickness, thereby maintaining heat dissipation performance of an original metal material.

According to the first aspect or any implementation of the first aspect, a thickness of the chemical conversion film is less than or equal to 2 µm. Such moderate thickness of the chemical conversion film can ensure an anti-corrosion effect without taking up excessive space of the structural member.

According to the first aspect or any implementation of the first aspect, a component of the chemical conversion film includes a phosphate and a metal oxide. In this way, due to high heat dissipation performance of the phosphate chemical conversion film, a heat dissipation capability of the first structural member or a magnesium-containing assembly cannot be affected.

According to a second aspect, this application provides a magnesium-containing assembly, including:
a middle frame, where the middle frame includes a body and a first swing arm connected to the body, and the middle frame is made of a magnesium alloy; and
a rotating shaft, where the rotating shaft includes a body and a second swing arm connected to the body, and the rotating shaft is made of steel;
the middle frame and the rotating shaft are connected and fixed by the first swing arm and the second swing arm; and
a composite film is attached to a contact surface between the first swing arm and the second swing arm, the composite film includes an adhesive film and Mylar, the adhesive film in the composite film is attached to a surface of the first swing arm, and the Mylar in the composite film faces the second swing arm.

According to the second aspect, in the magnesium-containing assembly of this application, for a region with severe galvanic corrosion, that is, the contact surface region between the middle frame and the rotating shaft (or between the first swing arm and the second swing arm), directionally reinforced anti-corrosion is performed by attaching the adhesive film/Mylar composite film to the contact region, thereby achieving a high anti-corrosion effect. In addition, the adhesive film in the composite film is attached to the surface of the first swing arm, and the Mylar in the composite film faces the second swing arm. In this way, the magnesium alloy middle frame body can be sealed, thereby effectively preventing entry of salt spray and other corrosive media, and an ion channel between the middle frame and the rotating shaft can be blocked, thereby preventing galvanic corrosion between the middle frame and the rotating shaft.

According to the second aspect or any implementation of the second aspect, a thickness of the composite film is 0.01 mm to 0.1 mm. Such moderate thickness of the composite film can ensure an anti-corrosion effect without taking up excessive space of the structural member.

According to the second aspect or any implementation of the second aspect, a length of the composite film is at least 0.02 mm greater than a length of the contact surface, and a width of the composite film is at least 0.02 mm greater than a width of the contact surface. The width of the composite film is at least 0.02 mm greater than the width of the contact surface. In this way, the composite film can cover the contact surface, thereby ensuring an anti-corrosion effect, and preventing corrosion in an edge region of the contact surface.

According to the second aspect or any implementation of the second aspect, a chemical conversion film is formed on a surface of the middle frame or the body of the middle frame. In this way, overall anti-corrosion is performed in a non-contact weak corrosion region between the middle frame and the rotating shaft by using a salt chemical conversion film with a small thickness, thereby maintaining heat dissipation performance of an original metal material.

According to the second aspect or any implementation of the second aspect, a thickness of the chemical conversion film is less than or equal to 2 µm. Such moderate thickness of the chemical conversion film can ensure an anti-corrosion effect without taking up excessive space of the structural member.

According to the second aspect or any implementation of the second aspect, a component of the chemical conversion film includes a phosphate and a metal oxide. In this way, due to high heat dissipation performance of the phosphate chemical conversion film, a heat dissipation capability of a first structural member or the magnesium-containing assembly cannot be affected.

According to the second aspect or any implementation of the second aspect, an anti-corrosion coating is formed on the surface of the first swing arm, and the composite film is attached to the anti-corrosion coating. Such addition of the anti-corrosion coating can provide a better anti-corrosion effect. The anti-corrosion coating may be any coating commonly used in the art, and may be formed by a common method.

According to the second aspect or any implementation of the second aspect, the first swing arm and the second swing arm are connected and fixed by a fastener, by adhesive dispensing, or by snap-fitting. Such connection has a simple structure and low costs.

According to the second aspect or any implementation of the second aspect, the fastener is made of a material with a potential difference between the material and magnesium less than a specified value. In this way, galvanic corrosion between the fastener and the middle frame can be prevented. The specified value is a maximum potential difference between the fastener and the middle frame without galvanic corrosion, and may be limited based on a specific material, which is not specifically limited herein.

According to the second aspect or any implementation of the second aspect, an anti-corrosion coating is formed on a surface of the fastener by electrophoresis or physical vapor deposition. In this way, galvanic corrosion between the fastener and the middle frame can be prevented. The anti-corrosion coating may be any coating commonly used in the art, and may be formed by a common method.

According to a third aspect, this application provides an electronic device, including the magnesium-containing assembly according to the second aspect.

According to the third aspect, due to the magnesium-containing assembly obtained based on the anti-corrosion method according to the first aspect of this application, both a good anti-corrosion effect and excellent heat dissipation performance are provided.

### BRIEF DESCRIPTION OF DRAWINGS

FIG. 1 is a schematic diagram of a structure of an electronic device in a flattened state according to an embodiment of this application;
FIG. 2 is a schematic diagram of a structure of the electronic device shown in FIG. 1 in an intermediate state;
FIG. 3 is a schematic diagram of a structure of the electronic device shown in FIG. 1 in a closed state;
FIG. 4 is a schematic diagram of a structure of another electronic device in an intermediate state according to an embodiment of this application;
FIG. 5 is a schematic diagram of a principle of galvanic corrosion between a magnesium alloy and steel;
FIG. 6 is a schematic diagram of galvanic corrosion that occurs when a magnesium alloy and steel are in contact in an electronic device;
FIG. 7 is a schematic diagram of a principle of preventing galvanic corrosion between a magnesium alloy and steel according to an embodiment of this application;
FIG. 8 is a schematic diagram of structures of a middle frame and a rotating shaft according to an embodiment of this application; and
FIG. 9 is a schematic sectional view of a connection between a middle frame and a rotating shaft according to an embodiment of this application.

### DESCRIPTION OF EMBODIMENTS

The technical solutions in embodiments of this application are clearly and completely described in the following with reference to the accompanying drawings in the embodiments of this application. Apparently, the described embodiments are merely some rather than all of the embodiments of this application. All other embodiments obtained by a person of ordinary skill in the art based on the embodiments of this application without making creative efforts shall fall within the protection scope of this application.

The term "and/or" herein describes only an association relationship between associated objects and indicates that three relationships may exist. For example, A and/or B may indicate the following three cases: Only A exists, both A and B exist, and only B exists.

In the specification and claims in the embodiments of this application, the terms "first", "second", and the like are intended to distinguish between different objects, but do not indicate a particular order of the objects. For example, a first target object, a second target object, and the like are intended to distinguish between different target objects, but do not indicate a particular order of the target objects.

In the embodiments of this application, the word such as "example" or "for example" is used to indicate an example, illustration, or description. Any embodiment or design scheme described as an "example" or "for example" in the embodiments of this application should not be explained as being more preferred or having more advantages than another embodiment or design scheme. Exactly, use of the word such as "example" or "for example" is intended to present a related concept in a specific manner.

In the descriptions of the embodiments of this application, unless otherwise specified, "a plurality of" means two or more. For example, a plurality of processing units mean two or more processing units; and a plurality of systems mean two or more systems.

An embodiment of this application provides an electronic device. The electronic device includes, but is not limited to, a terminal device with a folding function, such as a foldable mobile phone, a foldable tablet computer, a foldable game machine, or a foldable personal digital assistant (personal digital assistant, PDA). A specific form of the foregoing terminal device is not limited in the embodiments of this application.

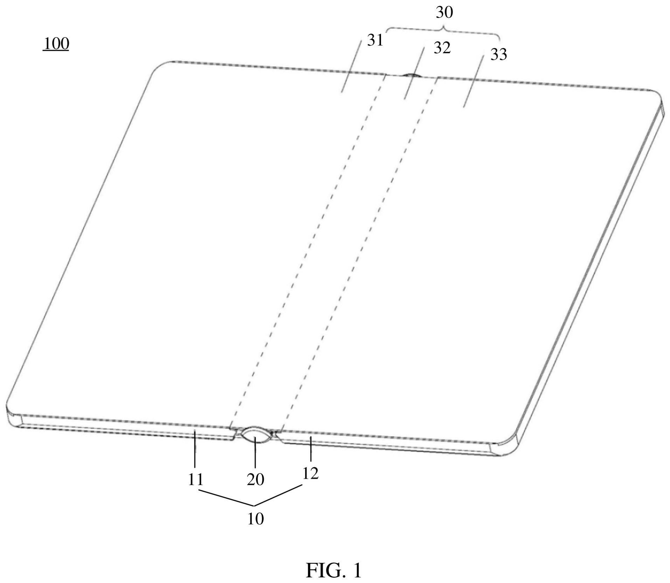

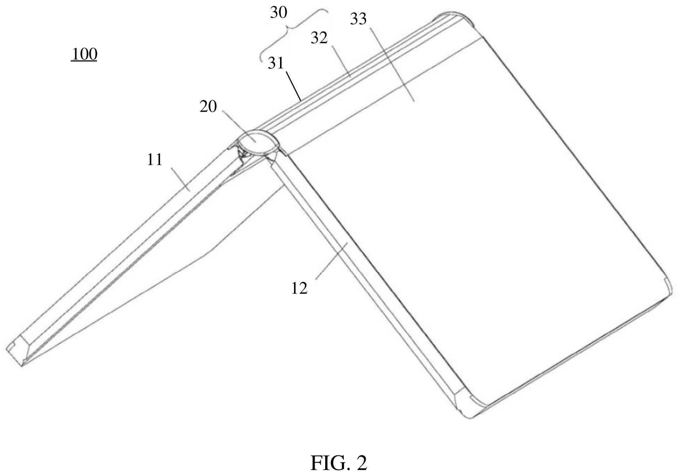

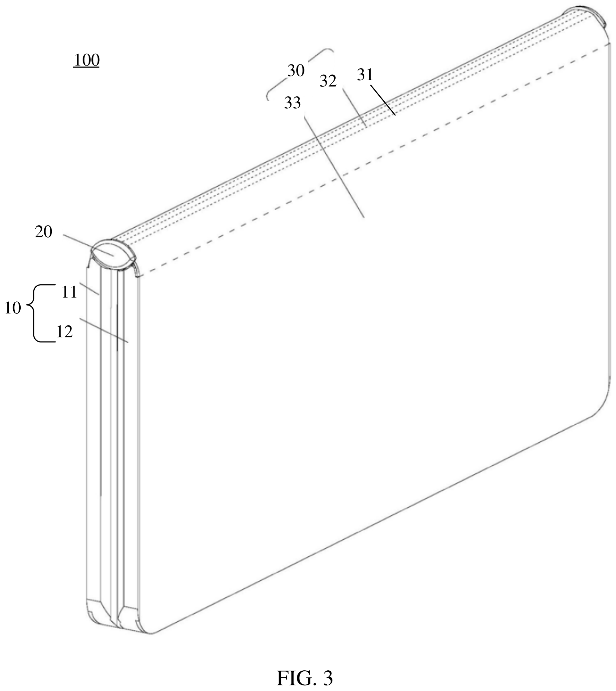

As shown in FIG. 1 to FIG. 3, an electronic device 100 includes a housing 10, a folding hinge 20, and a flexible display screen 30. The folding hinge 20 can deform to make a first housing 11 and a second housing 12 folded or unfolded relative to each other. As shown in FIG. 1, the first housing 11 and the second housing 12 may be unfolded relative to each other to a flattened state, so that the electronic device 100 is in the flattened state. For example, when the first housing 11 and the second housing 12 are in the flattened state, the first housing 11 and the second housing 12 may be at an angle of approximately 180° (with a little deviation allowed, such as 165°, 177°, or 185°). As shown in FIG. 2, the first housing 11 and the second housing 12 may be rotated (unfolded or folded) relative to each other to an intermediate state, so that the electronic device 100 is in the intermediate state. As shown in FIG. 3, the first housing 11 and the second housing 12 may be folded relative to each other to a closed state, so that the electronic device 100 is in the closed state. For example, when the first housing 11 and the second housing 12 are in the closed state, the first housing 11 and the second housing 12 may be completely folded to be parallel to each other (with a little deviation allowed). The intermediate state shown in FIG. 2 may be any state between the flattened state and the closed state. In this case, the electronic device 100 may switch between the flattened state and the closed state through the deformation of the folding hinge 20.

In some embodiments, the flexible display screen 30 is configured to display an image. For example, the flexible display screen 30 may be an organic light-emitting diode (organic light emitting diode, OLED) display screen, an active matrix organic light-emitting diode (active matrix organic light emitting diode, AMOLED) display screen, a mini light-emitting diode (mini organic light emitting diode) display screen, a micro light-emitting diode (micro organic light-emitting diode) display screen, a micro organic light-emitting diode (micro organic light-emitting diode) display screen, or a quantum dot light-emitting diode (quantum dot light emitting diodes, QLED) display screen.

The flexible display screen 30 includes a first non-bendable portion 31, a bendable portion 32, and a second non-bendable portion 33 that are arranged in sequence. The flexible display screen 30 is fixed on the housing 10. For example, the flexible display screen 30 may be bonded to the housing 10 through an adhesive layer. The first non-bendable portion 31 of the flexible display screen 30 is fixed on the first housing 11, and the second non-bendable portion 33 is fixed on the second housing 12. In a process in which the first housing 11 and the second housing 12 are folded or unfolded relative to each other, the bendable portion 32 deforms. As shown in FIG. 1, when the first housing 11 and the second housing 12 are in the flattened state, the flexible display screen 30 is in a flattened shape. As shown in FIG. 2, when the first housing 11 and the second housing 12 are in the intermediate state, the flexible display screen 30 is in an intermediate shape between a flattened shape and a closed shape. As shown in FIG. 3, when the first housing 11 and the second housing 12 are in the closed state, the flexible display screen 30 is in a closed shape. When the electronic device 100 is in a closed state, the flexible display screen 30 is located on an outer side of the housing 10, and the flexible display screen 30 may be substantially U-shaped.

In this embodiment, the flexible display screen 30 can be unfolded or folded with the help of the folding hinge 20. When the electronic device 100 is in a flattened state, the flexible display screen 30 is in a flattened shape, which can provide a display in full screen, so that the electronic device 100 has a large display area, improving viewing experience of a user. When the electronic device 100 is in a closed state, the electronic device 100 has a small plane size (a small width), so that the electronic device 100 can be carried and stored easily by a user.

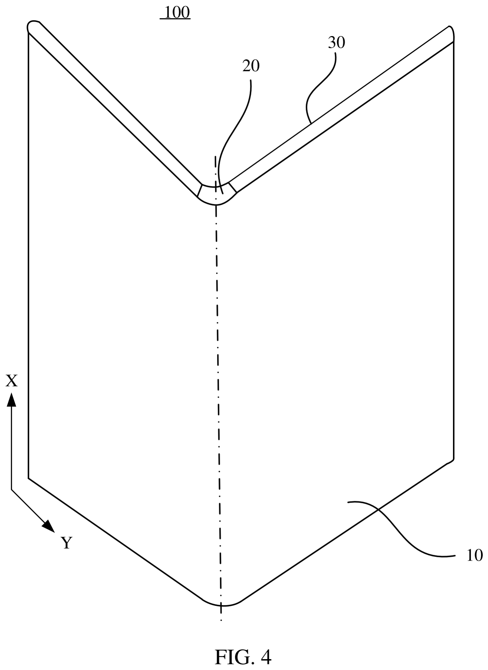

As shown in FIG. 4, an electronic device 100 includes a housing 10, a folding hinge 20, and a flexible screen 30. The flexible screen 30 is fixed on a surface of a side of the housing 10. The electronic device 100 may be folded along a center of the electronic device 100. When a foldable mobile phone is in a folded state, that is, when a folding angle of the foldable mobile phone is 0, a size of the foldable mobile phone can be reduced. When the foldable mobile phone is in an unfolded state, that is, when a folding angle of the foldable mobile phone is 180°, the flexible screen 30 is in a state with a maximum display area. In this case, a user may perform an operation on the flexible screen 30. It needs to be noted that, the folding angle refers to an included angle between left and right parts of the foldable mobile phone. Different from the electronic device shown in FIG. 1 to FIG. 3, when the electronic device 100 in FIG. 4 is in a closed state, the flexible display screen 30 is located on an inner side of the housing 10.

To clearly describe the technical solutions in the embodiments of this application, as shown in FIG. 4, three directions may be defined: a length direction (an X direction, also referred to as a first direction) of the foldable mobile phone, a width direction (a Y direction, also referred to as a second direction) of the foldable mobile phone, and a thickness direction (a Z direction, also referred to as a third direction) of the foldable mobile phone.

In addition, in the embodiments of this application, "up", "down", "left", and "right" refer to directions determined, with hands of a user as reference, when the foldable mobile phone is in an unfolded state, the user holds the foldable mobile phone with both hands, and the flexible screen 30 faces the user.

It may be understood that this embodiment is described using an example in which "a rotation center of the electronic device 100 is parallel to a length direction of the electronic device 100". In this case, the electronic device 100 can rotate left and right, and folding and unfolding of the electronic device 100 affect a width of the electronic device 100. In some other embodiments, a rotation center of the electronic device 100 may alternatively be parallel to a width direction of the electronic device 100. In this case, the electronic device 100 can rotate up and down, and folding and unfolding of the electronic device 100 affect a length of the electronic device 100.

For the electronic devices shown in FIG. 1 to FIG. 4, to reduce a weight of the device, a common method at present is to manufacture a middle frame by using a magnesium alloy, which reduces the overall weight of the device compared to use of a steel material. However, a rotating shaft or hinge, as a key mechanism of the foldable device, still requires a steel material for strength and other reasons, and the middle frame needs to be connected and fixed to the rotating shaft. As described above, when a magnesium alloy and steel are in contact, due to a large potential difference between the magnesium alloy (about -2.363 V) and the steel (about -0.441 V), a contact surface between the middle frame and the rotating shaft is usually prone to severe galvanic corrosion. This not only affects connection strength, but also causes risks of jamming and foreign matter in the rotating shaft, and electrical connection failure.

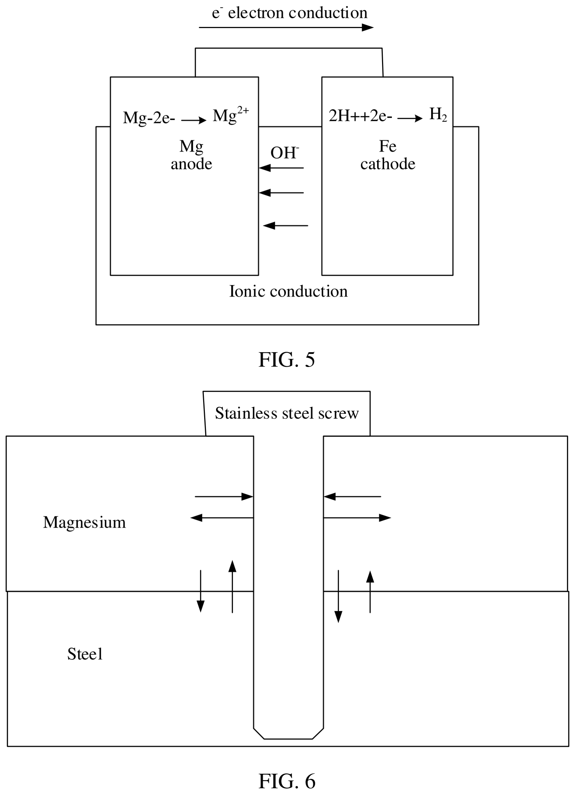

FIG. 5 is a schematic diagram of a principle of galvanic corrosion. An example in which steel/iron is used as a metal in contact with a magnesium alloy is used. As shown in FIG. 5, three necessary conditions need to be met for galvanic corrosion to occur: first, there is a sufficient potential difference; second, there is an electron channel; and third, there is an ion channel. In a case that magnesium is an anode and iron is a cathode, there is a sufficient potential difference between magnesium and iron, so galvanic corrosion occurs when there are an electron channel and an ion channel.

FIG. 6 is a schematic diagram of galvanic corrosion that occurs when a magnesium alloy and steel are in contact in an electronic device. As shown in FIG. 6, in the electronic device, for example, a foldable device, galvanic corrosion tends to occur when a structural member made of the magnesium alloy (for example, a middle frame) and a structural member made of the steel (for example, a rotating shaft) are in contact, for the following reasons: First, there is a large potential difference between the magnesium alloy middle frame and the steel rotating shaft. Second, there is a need for an electrical connection between the magnesium alloy middle frame and the steel rotating shaft (an electrical connection needs to be formed between the middle frame and the rotating shaft for discharging). These already meet two conditions for galvanic corrosion. In this case, when the electronic device is in a salt spray environment, because the salt spray environment provides the third condition for galvanic corrosion (there is an ion channel), galvanic corrosion easily tends to occur between the magnesium alloy middle frame and the steel rotating shaft in the salt spray environment.

To overcome this problem, at present, an overall anti-corrosion scheme with a full-coverage polymer coating (such as electrophoresis or paint spraying) is mainly applied. However, this method has the following problems: In an aspect, inhibition of galvanic corrosion by this method is limited. In another aspect, the full-coverage polymer coating has an unfavorable effect on a non-magnesium/steel contact region, resulting in a great decrease in a heat dissipation capability of the magnesium alloy.

Base on this, the embodiments of this application provide an anti-corrosion method for a magnesium-containing structural member, and a magnesium-containing structural member to be applied to a foldable device in the embodiments of this application, to provide a good anti-corrosion effect while reducing a weight of the device by using a magnesium alloy material, without affecting a heat dissipation capability of the magnesium-containing structural member.

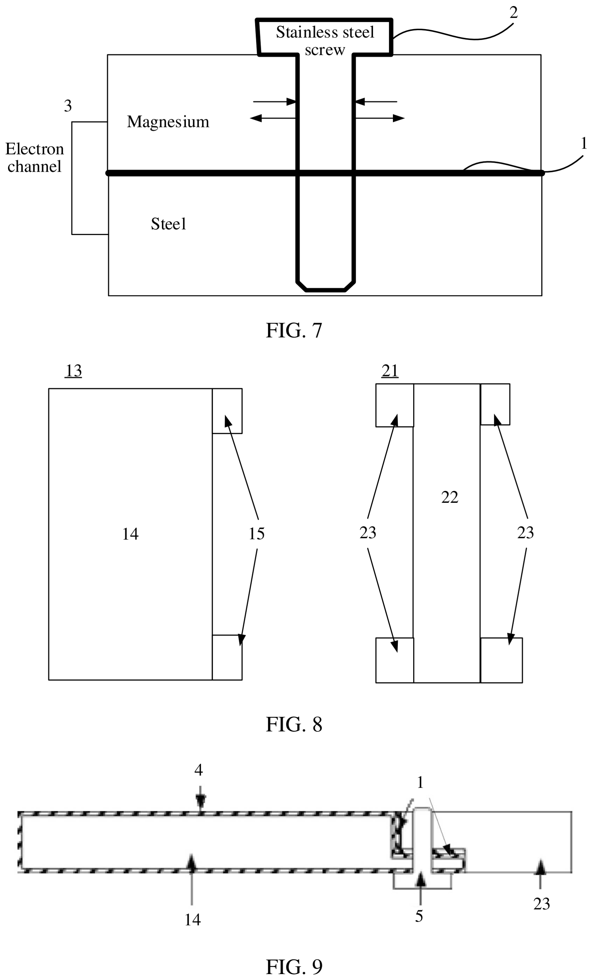

FIG. 7 is a schematic diagram of a principle of preventing galvanic corrosion between a magnesium alloy and steel according to an embodiment of this application. As shown in FIG. 7, in this embodiment of this application, to prevent galvanic corrosion that occurs when a structural member made of the magnesium alloy (for example, a middle frame) and a structural member made of the steel (for example, a rotating shaft) are in contact, the following method may be applied:

First, a composite film 1 including an adhesive film and Mylar is attached to a contact surface between the structural member made of the magnesium alloy (for example, the middle frame) and the structural member made of the steel (for example, the rotating shaft). A surface of the adhesive film is attached to the structural member made of the magnesium alloy, and a surface of the Mylar is in contact with the structural member made of the steel. This is because, if the adhesive film is attached to the structural member made of the steel, an anti-galvanic corrosion effect is weakened, and the magnesium alloy body has a risk of chemical corrosion. The adhesive film of the adhesive film/Mylar composite film 1 is attached to the surface of the magnesium alloy, so that the magnesium alloy body can be sealed, thereby effectively preventing entry of salt spray and other corrosive media, and an ion channel between the structural member made of the magnesium alloy (for example, the middle frame) and the structural member made of the steel (for example, the rotating shaft) can be blocked, thereby preventing galvanic corrosion between the structural member made of the magnesium alloy (for example, the middle frame) and the structural member made of the steel (for example, the rotating shaft). In addition, compared to the current anti-corrosion scheme with a coating on a surface of a magnesium alloy by spraying, electrophoresis, or the like, an effect of isolating ions by the Mylar is better, and therefore an inhibition effect on anti-galvanic corrosion by this method is apparent.

Further, for the composite film 1 to have an effect of isolating ions, the adhesive film/Mylar composite film 1 requires a specific thickness, and the thickness of the composite film 1 cannot be excessively large, because an excessively large thickness no longer improves the anti-corrosion effect, but takes up limited structural space. For example, the thickness of the composite film 1 including the adhesive film and the Mylar may be 0.01 mm to 0.1 mm, such as 0.01 mm, 0.05 mm, or 0.1 mm. Such thickness can effectively isolate ions, but cannot take up structural space.

Further, due to corrosion that occurs at an edge position of a contact region between the structural member made of the magnesium alloy (for example, the middle frame) and the structural member made of the steel, the composite film 1 has to be larger than the contact region. For example, in an embodiment of this application, a length of the composite film 1 is at least 0.02 mm greater than a length of the contact region, and a width of the composite film 1 is at least 0.02 mm greater than a width of the contact region, so that the composite film 1 fully covers the contact region. In this way, an ion channel between the structural member made of the magnesium alloy (for example, the middle frame) and the structural member made of the steel (for example, the rotating shaft) can be blocked, thereby preventing galvanic corrosion between the structural member made of the magnesium alloy (for example, the middle frame) and the structural member made of the steel (for example, the rotating shaft).

Second, as the magnesium alloy body has a risk of chemical corrosion, for the structural member made of the magnesium alloy, overall anti-corrosion may be performed on the magnesium alloy structural member by using a phosphate chemical conversion film, that is, a chemical conversion film is formed on a surface of the magnesium alloy structural member or a surface of a non-contact region of the magnesium alloy structural member for anti-corrosion. For example, the chemical conversion film is a salt anti-corrosion film with main components of a phosphate and a metal oxide. Due to an excellent heat dissipation capability of the salt film, the chemical conversion film can inhibit corrosion of the magnesium alloy and ensure high thermal conductivity of the metal body. For example, to provide both a heat dissipation capability and an anti-corrosion effect, a thickness of the chemical conversion film is less than or equal to 2 µm.

Third, as the structural member made of the magnesium alloy (for example, the middle frame) and the structural member made of the steel (for example, the rotating shaft) are fixed by a fastener, for example, a stainless steel screw, galvanic corrosion may also occur between the fastener and the structural member made of the magnesium alloy. In this case, to prevent galvanic corrosion between the fastener and the structural member made of the magnesium alloy, in an embodiment of this application, a potential difference between dissimilar metals may be reduced, or an electrical connection between the fastener and the magnesium alloy may even be cut off, for example, a fastener with a small potential difference between the fastener and the magnesium alloy is used. For example, the fastener is made of a material with a potential difference between the material and magnesium less than a specified value. In this way, galvanic corrosion between the fastener and the middle frame can be prevented. The specified value is a maximum potential difference between the fastener and the middle frame without galvanic corrosion, and may be limited based on a specific material, which is not specifically limited herein. Alternatively, the electrical connection between the fastener and the magnesium alloy is cut off by galvanization, electrophoretic coating, or deposition of a non-conductive PVD film layer 2 on a surface of the fastener, to inhibit galvanic corrosion.

Fourth, for a foldable device, there is a need for an electrical connection between the structural member made of the magnesium alloy (for example, the middle frame) and the structural member made of the steel. To implement the electrical connection between the structural member made of the magnesium alloy and the structural member made of the steel without causing galvanic corrosion, an elastic sheet or conductive cotton 3 may be used in a non-direct contact region between the structural member made of the magnesium alloy (for example, the middle frame) and the structural member made of the steel for the electrical connection, to meet a need for the electrical connection between magnesium and steel.

According to the anti-corrosion method for the magnesium-containing structural member provided in the embodiments of this application, an anti-corrosion design with region division is applied. For a non-contact weak corrosion region of magnesium/steel, overall anti-corrosion is performed by using a salt chemical conversion film with a small thickness, thereby maintaining heat dissipation performance of an original metal material. For a contact region of magnesium/steel with severe galvanic corrosion, directionally reinforced anti-corrosion is performed by attaching the adhesive film/Mylar composite film to the surface of the magnesium alloy. In this way, through coupling of the overall anti-corrosion and the directional anti-corrosion, high corrosion resistance of a connection between the magnesium alloy middle frame and the steel rotating shaft in the foldable device and excellent heat dissipation performance of the middle frame are achieved.

FIG. 8 is a schematic diagram of structures of a middle frame and a rotating shaft according to an embodiment of this application. FIG. 9 is a schematic sectional view of a connection between a middle frame and a rotating shaft according to an embodiment of this application.

As shown in FIG. 8 and FIG. 9, the magnesium-containing structural member provided in the embodiments of this application is, for example, a middle frame 13 made of a magnesium alloy. As a part of the first housing 11 or the second housing 12, the middle frame 13 includes a middle frame body 14 and a first swing arm 15 connected to or integrated with the middle frame body 14. The middle frame 13 is connected to a rotating shaft by the first swing arm 15 to rotate relative to the rotating shaft. The steel structural member provided in the embodiments of this application is, for example, a rotating shaft 21 made of steel. As a part of the folding hinge, the rotating shaft 21 includes a rotating shaft body 22 and a second swing arm 23 connected to or integrated with the rotating shaft body 22.

For example, in an embodiment of this application, in an X direction (or a length direction), two first swing arms 15 are disposed on a side of the middle frame 13, and the two first swing arms 15 are, for example, disposed respectively at both ends of the middle frame 13. In the X direction (or the length direction), two second swing arms 23 are disposed respectively on both sides of the rotating shaft 21, and the two second swing arms 23 are, for example, disposed respectively at both ends of the rotating shaft 21. Structures and shapes of the middle frame 13, the rotating shaft 21, the first swing arm 15, and the second swing arm 23 are examples. The embodiments of this application are intended to describe a principle of anti-corrosion between the middle frame and the rotating shaft, but are not intended to limit the structures of the middle frame, the rotating shaft, and the swing arm. The embodiments of this application are applicable to anti-corrosion between the middle frame and the rotating shaft of various structures.

As shown in FIG. 9, when the middle frame 13 and the rotating shaft 21 are connected, the first swing arm 15 and the second swing arm 23 may be connected and fixed by a fastener 5, for example, a screw, to implement a connection between the middle frame 13 and the rotating shaft 21. Certainly, other than by a fastener, for example, a screw, the first swing arm 15 and the second swing arm 23 may be fixed by adhesive dispensing or in another manner, for example, by snap-fitting.

As shown in FIG. 9, to prevent galvanic corrosion between the middle frame 13 and the rotating shaft 21, in an embodiment of this application, the composite film 1 including the adhesive film and the Mylar is attached to a contact region between the middle frame 13 and the rotating shaft 21, specifically between the first swing arm 15 and the second swing arm 23. A surface of the adhesive film is attached to the structural member made of the magnesium alloy, and a surface of the Mylar is in contact with the structural member made of the steel. This is because, if the adhesive film is attached to the structural member made of the steel, an anti-galvanic corrosion effect is weakened, and the magnesium alloy body has a risk of chemical corrosion. The adhesive film of the adhesive film/Mylar composite film 1 is attached to the surface of the magnesium alloy, so that the magnesium alloy body can be sealed, thereby effectively preventing entry of salt spray and other corrosive media, and an ion channel between the structural member made of the magnesium alloy (for example, the middle frame) and the structural member made of the steel (for example, the rotating shaft) can be blocked, thereby preventing galvanic corrosion between the structural member made of the magnesium alloy (for example, the middle frame) and the structural member made of the steel (for example, the rotating shaft). In addition, compared to the current anti-corrosion scheme with a coating on a surface of a magnesium alloy by spraying, electrophoresis, or the like, an effect of isolating ions by the Mylar is better, and therefore an inhibition effect on anti-galvanic corrosion by this method is apparent.

Further, for the composite film 1 to have an effect of isolating ions, the adhesive film/Mylar composite film 1 requires a specific thickness, and the thickness of the composite film 1 cannot be excessively large, because an excessively large thickness no longer improves the anti-corrosion effect, but takes up limited structural space. For example, the thickness of the composite film 1 including the adhesive film and the Mylar may be 0.01 mm to 0.1 mm, such as 0.01 mm, 0.05 mm, or 0.1 mm. Such thickness can effectively isolate ions, but cannot take up structural space.

Further, due to corrosion that occurs at an edge position of a contact region between the structural member made of the magnesium alloy (for example, the middle frame) and the structural member made of the steel, the composite film 1 has to be larger than the contact region. For example, in an embodiment of this application, a length of the composite film 1 is at least 0.02 mm greater than a length of the contact region, and a width of the composite film 1 is at least 0.02 mm greater than a width of the contact region, so that the composite film 1 fully covers the contact region. In this way, an ion channel between the structural member made of the magnesium alloy (for example, the middle frame) and the structural member made of the steel (for example, the rotating shaft) can be blocked, thereby preventing galvanic corrosion between the structural member made of the magnesium alloy (for example, the middle frame) and the structural member made of the steel (for example, the rotating shaft).

Still refer to FIG. 9. To implement anti-corrosion of the middle frame 13 made of the magnesium alloy, in an embodiment of this application, a chemical conversion film is formed on a surface of the middle frame 13 or a surface of the middle frame body 14. For example, the chemical conversion film is a salt anti-corrosion film with main components of a phosphate and a metal oxide. Due to an excellent heat dissipation capability of the salt film, the chemical conversion film can inhibit corrosion of the magnesium alloy and ensure high thermal conductivity of the metal body. For example, to provide both a heat dissipation capability and an anti-corrosion effect, a thickness of the chemical conversion film is less than or equal to 2 µm.

It should be understood that, to improve an anti-corrosion effect, in an embodiment of this application, another auxiliary coating may be further formed on the contact region between the middle frame 13 and the rotating shaft 21 or on the surface of the middle frame 13, to achieve a better anti-corrosion effect. Moreover, in addition to anti-corrosion between the magnesium alloy and the steel, the principle of anti-corrosion in this application may also be applied to anti-corrosion between other dissimilar metals.

To verify an anti-corrosion effect of the anti-corrosion method or the magnesium-containing assembly in the embodiments of this application, the following experiments are carried out.

### Example:

In an electronic device, a first swing arm of a magnesium alloy middle frame and a second swing arm of a rotating shaft are connected by a screw. A surface of the magnesium alloy middle frame is covered with a chemical conversion film with a thickness of about 1 µm. A component of the chemical conversion film mainly includes calcium phosphate and manganese oxide. An adhesive film/Mylar composite film is attached to a side wall of the magnesium alloy middle frame, that is, a contact region between the middle frame and the swing arm of the rotating shaft. A total thickness of the composite film is 0.03 mm.

### Comparative Example:

In an electronic device, two swing arms of a middle frame and a swing arm of a rotating shaft are connected by a screw. A surface of a magnesium alloy is fully covered with a polymer electrophoretic coating with a thickness of about 15 µm.

Then, the electronic devices in the Example and the Comparative Example are subjected to an anti-corrosion test and a temperature rise test in a salt spray environment. Test results are shown in Table 1.

**Table 1**

| Scheme | Scheme description | Salt spray effect | Temperature rise of the whole device |
|---|---|---|---|
| Example | 0.03 mm adhesive film/Mylar composite film + chemical conversion film | Good | A |
| Comparative Example | Polymer electrophoretic coating with a thickness of 0.015 mm | Severe, large-area corrosion | A+1.6°C |

In conclusion, a good anti-corrosion effect and excellent heat dissipation performance can be achieved by using the anti-corrosion method or using the electronic device including the magnesium-containing assembly in the embodiments of this application.

The foregoing embodiments are merely intended for describing the technical solutions of this application, but not for limiting this application. Although this application is described in detail with reference to the foregoing embodiments, a person of ordinary skill in the art should understand that modifications may still be made to the technical solutions described in the foregoing embodiments, or equivalent replacements may still be made to some technical features therein; and these modifications or replacements do not cause the essence of the corresponding technical solutions to depart from the scope of the technical solutions in the embodiments of this application.

## Claims

1. An anti-corrosion method, applied to a contact surface between a first structural member and a second structural member, wherein the anti-corrosion method comprises: attaching a composite film to the contact surface between the first structural member and the second structural member, wherein the composite film comprises an adhesive film and Mylar.

2. The anti-corrosion method according to claim 1, wherein a thickness of the composite film is 0.01 mm to 0.1 mm.

3. The anti-corrosion method according to claim 1, wherein a length of the composite film is at least 0.02 mm greater than a length of the contact surface, and a width of the composite film is at least 0.02 mm greater than a width of the contact surface.

4. The anti-corrosion method according to any one of claims 1 to 3, wherein the first structural member is a magnesium-containing structural member, the second structural member is a steel structural member, the adhesive film in the composite film is attached to the first structural member, and the Mylar in the composite film faces the second structural member.

5. The anti-corrosion method according to claim 4, wherein a chemical conversion film is formed on a surface of the first structural member.

6. The anti-corrosion method according to claim 5, wherein a thickness of the chemical conversion film is less than or equal to 2 µm.

7. The anti-corrosion method according to claim 5, wherein a component of the chemical conversion film comprises a phosphate and a metal oxide.

8. A magnesium-containing assembly, comprising:
a middle frame, wherein the middle frame comprises a body and a first swing arm connected to the body, and the middle frame is made of a magnesium alloy; and
a rotating shaft, wherein the rotating shaft comprises a body and a second swing arm connected to the body, and the rotating shaft is made of steel;
the middle frame and the rotating shaft are connected and fixed by the first swing arm and the second swing arm; and
a composite film is attached to a contact surface between the first swing arm and the second swing arm, the composite film comprises an adhesive film and Mylar, the adhesive film in the composite film is attached to a surface of the first swing arm, and the Mylar in the composite film faces the second swing arm.

9. The magnesium-containing assembly according to claim 8, wherein a thickness of the composite film is 0.01 mm to 0.1 mm.

10. The magnesium-containing assembly according to claim 8, wherein a length of the composite film is at least 0.02 mm greater than a length of the contact surface, and a width of the composite film is at least 0.02 mm greater than a width of the contact surface.

11. The magnesium-containing assembly according to any one of claims 8 to 10, wherein a chemical conversion film is formed on a surface of the middle frame or the body of the middle frame.

12. The magnesium-containing assembly according to claim 11, wherein a thickness of the chemical conversion film is less than or equal to 2 µm.

13. The magnesium-containing assembly according to claim 11, wherein a component of the chemical conversion film comprises a phosphate and a metal oxide.

14. The magnesium-containing assembly according to any one of claims 8 to 10, wherein an anti-corrosion coating is formed on the surface of the first swing arm, and the composite film is attached to the anti-corrosion coating.

15. The magnesium-containing assembly according to any one of claims 8 to 10, wherein the first swing arm and the second swing arm are connected and fixed by a fastener, by adhesive dispensing, or by snap-fitting.

16. The magnesium-containing assembly according to claim 15, wherein the fastener is made of a material with a potential difference between the material and magnesium less than a specified value.

17. The magnesium-containing assembly according to claim 15, wherein an anti-corrosion coating is formed on a surface of the fastener by electrophoresis or physical vapor deposition.

18. An electronic device, comprising the magnesium-containing assembly according to any one of claims 10 to 17.
